# FASCICULE DE BREVET EUROPEEN

(11) **EP 2 980 992 B1**
(45) Date de publication et mention de la délivrance du brevet: **22.07.2020**
(21) Numéro de dépôt: 15179024.3
(22) Date de dépôt: 30.07.2015
(51) Int. Cl.: H03K 5/13, G06F 1/10, G06F 13/16

(54) **CIRCUIT INTÉGRÉ PHOTORÉPÉTÉ AVEC COMPENSATION DES RETARDS DE PROPAGATION DE SIGNAUX, NOTAMMENT DE SIGNAUX D'HORLOGE**
INTEGRIERTER LITHOGRAFISCH VERVIELFÄLTIGTER SCHALTKREIS MIT KOMPENSATION DER LAUFZEITVERZÖGERUNGEN VON SIGNALEN, INSBESONDERE VON TAKTSIGNALEN
PHOTOREPEATED INTEGRATED CIRCUIT WITH COMPENSATION OF SIGNAL PROPAGATION DELAYS, ESPECIALLY CLOCK SIGNALS

(30) Priorité: 01.08.2014 FR 1457486
(43) Date de publication de la demande: 03.02.2016
(73) Titulaire: Pyxalis, 38430 Moirans (FR)
(72) Inventeur: CHENEBAUX, Grégoire, 38000 Grenoble (FR)
(74) Mandataire: Priori, Enrico

(56) Documents cités:
- EP-A1- 2 680 153
- US-A1- 2008 201 597
- US-A1- 2009 161 453

## Description

L'invention concerne les circuits intégrés de grande dimension à motifs juxtaposés répétitifs, produits par exposition partielle répétée d'un même motif dans plusieurs zones d'un même substrat.

Cette technique de réalisation est parfois appelée technique de "stitching" ; elle consiste à utiliser lors d'une étape d'exposition photolithographique d'un substrat de circuit intégré un même masque définissant le motif à reproduire, masque qui est décalé successivement d'une zone du substrat à une autre zone adjacente, au cours de sous-étapes d'exposition. L'étape de photolithographie constituée par cette succession de sous-étapes peut être complétée par d'autres sous-étapes d'exposition de zones supplémentaires correspondant à des motifs différents, donc exposées à travers un ou plusieurs masques différents. L'étape de photolithographie est par exemple une étape de définition d'un motif de conducteurs dans une couche conductrice déposée sur le substrat. D'autres étapes de photolithographie sont effectuées pour la fabrication du circuit intégré, et pour chacune d'elles on va également procéder par stitching, donc par exposition répétée d'un même motif dans des zones adjacentes ; on aboutit, à la fin de toutes les étapes de photolithographie et à la fin des traitements physiques ou chimiques associés, à un circuit intégré dont certaines zones, adjacentes les unes aux autres, sont rigoureusement identiques entre elles.

Dans les circuits intégrés ayant une dimension importante de plusieurs centimètres de côté et devant travailler à des vitesses de fonctionnement élevées, on se heurte à une difficulté qui est la vitesse de propagation limitée des signaux ; cette vitesse limitée engendre le risque qu'un même signal de commande, qui doit servir à commander simultanément plusieurs circuits identiques, soit transmis avec un décalage temporel non nul entre les différentes zones identiques. En particulier, dans les circuits qui fonctionnent avec une horloge à haute fréquence, un même signal d'horloge produit à un endroit du circuit intégré peut atteindre les différentes parties du circuit à des instants décalés les uns par rapport aux autres alors que ces signaux devraient arriver simultanément pour un bon fonctionnement de l'ensemble. Pour des circuits de plusieurs centimètres de côté, le décalage peut être de plusieurs dizaines de nanosecondes, ce qui n'est pas compatible avec des cadences de fonctionnement de plusieurs dizaines de mégahertz.

Le document US 2008/201597 décrit un système de mémoire dans lequel un signal d'horloge se propage d'un dispositif de mémoire à l'autre. Ce système comprend une interface mémoire incluant un circuit de compensation des retards de propagation des signaux, basé sur l'utilisation d'une ligne de retard à prises (« tapped delay line » en anglais) et de multiplexeurs pour sélectionner un parmi les signaux de sortie de ladite ligne de retard.

L'invention vise à faciliter la transmission des signaux, et notamment des signaux d'horloges dans de tels circuits stitchés de dimensions importantes, pour que les fronts de montée ou descente de ces signaux ne soient pas trop décalés dans le temps lorsqu'ils parviennent à des points semblables de zones identiques.

Pour cela, on propose selon l'invention un circuit intégré comprenant N motifs adjacents tous identiques, correspondant à N circuits partiels identiques adjacents de rang i = 1 à i= N dans l'ordre de succession géographique des circuits partiels, chaque circuit partiel comprenant une entrée de signal d'horloge amont, une sortie de signal d'horloge aval et une ligne conductrice principale s'étendant entre l'entrée de signal d'horloge amont et la sortie de signal d'horloge aval et introduisant un retard de propagation de durée T, la sortie de signal d'horloge aval de chaque circuit partiel, sauf celui de rang N, étant reliée directement à l'entrée de signal d'horloge amont du circuit partiel immédiatement suivant de telle sorte que les lignes conductrices principales des circuits partiels permettent la transmission en cascade d'un signal maître reçu sur le circuit partiel de rang 1, caractérisé en ce qu'il comprend dans chaque circuit partiel de rang i :
- une ligne conductrice de compensation à N sorties successives de rang i = 1 à N, reliée à la ligne principale du circuit partiel et établissant un retard de propagation de durée T entre les sorties successives,
- un multiplexeur à N entrées reliées respectivement à chacune des N sorties de la ligne conductrice de compensation,
- des lignes de commande du multiplexeur, agencées pour sélectionner l'entrée de rang i du multiplexeur, reliée à la sortie de rang N-i+1 parmi les N sorties de la ligne conductrice de compensation,
- la sortie du multiplexeur du circuit partiel de rang i fournissant un signal local (de préférence un signal d'horloge locale) pour ce circuit partiel,
- les lignes de commande du multiplexeur du circuit partiel de rang 1 reçoivent un signal de sélection de l'entrée de rang 1 de ce multiplexeur, et propagent ce signal d'un multiplexeur au suivant en le modifiant à chaque fois pour incrémenter d'une unité le rang de l'entrée sélectionnée, et ainsi décrémenter d'une unité le rang de la sortie sélectionnée. Ainsi, les lignes de commande aboutissant au multiplexeur du circuit partiel de rang i sélectionnent la sortie de rang N-i+1 de ce circuit et transmettent au multiplexeur du circuit partiel de rang i+1 une commande de sélection de la sortie de rang N-i.

Une manière de procéder consiste à utiliser N lignes de commande pour les multiplexeurs, parmi lesquelles seule une ligne de rang i (pour le multiplexeur du circuit de rang i) est active pour sélectionner l'entrée de rang i du multiplexeur, c'est-à-dire la sortie de rang N-i+1 de la ligne de compensation ; les autres lignes de commande sont inactives ; les lignes de commande reçues par le multiplexeur du circuit partiel de rang i sont reliées aux lignes de commande du multiplexeur du circuit partiel de rang i+1 avec une permutation circulaire pour que la ligne de commande active de rang i du multiplexeur du circuit partiel de rang i soit reliée à une ligne de commande de rang i+1 du multiplexeur du circuit partiel de rang i+1, cette dernière ligne sélectionnant, lorsqu'elle est active, la sortie de rang N-i de la ligne de compensation du circuit partiel de rang i+1.

Dans une réalisation pratique, un amplificateur tampon est inséré dans la ligne principale et un amplificateur tampon identique respectif est inséré dans la ligne de compensation, entre chaque sortie de celle-ci et la sortie de rang immédiatement suivant de la ligne. Les amplificateurs introduisent tous le même retard de propagation et sont en pratique tous identiques dans un circuit partiel donné et dans tous les autres circuits partiels.

D'autres caractéristiques et avantages de l'invention apparaîtront à la lecture de la description détaillée qui suit et qui est faite en référence aux dessins annexés dans lesquels :
- la figure 1 représente un schéma d'organisation générale d'un exemple de puce de circuit intégré obtenue par photorépétition de motifs rigoureusement identiques ;
- la figure 2 représente un schéma dans lequel un circuit de compensation est introduit dans chaque circuit partiel conformément à l'invention ;
- la figure 3 représente un schéma de réalisation du circuit de compensation de l'invention ;
- la figure 4 représente une réalisation du circuit de compensation avec un amplificateur tampon dans la ligne principale et des amplificateurs tampons dans les tronçons de la ligne de compensation ;
- la figure 5 représente un schéma de plusieurs circuits partiels juxtaposés, avec une commande du multiplexeur par simple permutation circulaire de l'ordre des N lignes de commande.

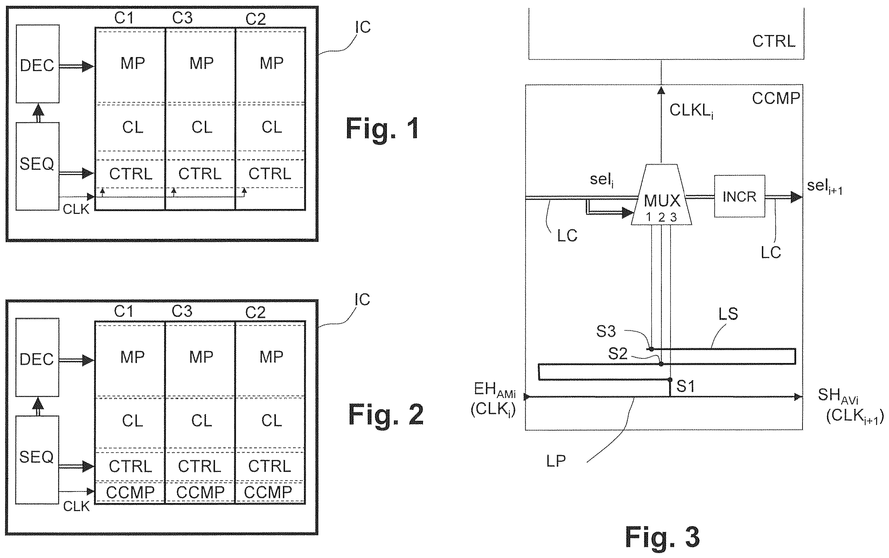

Pour illustrer l'invention, on a représenté sur la figure 1 une puce de circuit intégré IC réalisée en partie par photorépétition de motifs identiques, dans un exemple qui est un capteur d'image. La puce comprend dans cet exemple trois circuits partiels identiques C1, C2, C3 représentés sous forme de rectangles en traits pleins, et ce sont ces trois circuits qui sont réalisés par photorépétition d'un même motif. Il ne peut pas y avoir la moindre différence entre les trois circuits. Les motifs sont juxtaposés et des liaisons conductrices sont établies entre les circuits adjacents par simple aboutement d'un motif d'un circuit partiel avec un motif du circuit adjacent.

Dans cet exemple, chaque circuit partiel comprend une matrice MP de pixels photosensibles et, en bas de la matrice, un circuit de lecture CL pour recueillir les signaux issus des pixels du circuit partiel, et un circuit de commande digital CTRL pour commander les circuits de lecture du circuit partiel. Ces différents circuits sont délimités par des traits pointillés.

La puce peut comprendre par ailleurs d'autres circuits électroniques, non photorépétés, par exemple un circuit séquenceur général SEQ destiné à produire des signaux de commande pour les circuits partiels et notamment un signal d'horloge maître CLK qui sert de référence générale pour le déroulement des séquences de fonctionnement du capteur. Un autre circuit DEC comporte un décodeur de rangées pour l'adressage successif des lignes de la matrice lors des opérations de lecture des signaux issus des pixels. Ce décodeur adresse simultanément les lignes de même rang des matrices MP des trois circuits partiels. Cette organisation générale de la puce n'est donnée qu'à titre d'exemple, l'invention étant applicable quels que soient les circuits de la puce à partir du moment où on a besoin de contrôler étroitement la synchronisation des fronts de signaux d'horloge utilisés dans les différents circuits partiels identiques, ou la synchronisation d'autres signaux de commande utilisés dans les circuits partiels. Dans cette organisation, comme c'est bien connu pour des circuits formés par photorépétition, les circuits partiels sont connectés entre eux c'est-à-dire qu'un conducteur arrivant jusqu'à un bord latéral droit d'un circuit partiel est en contact direct avec un conducteur partant au même endroit du bord latéral gauche du circuit immédiatement adjacent de rang suivant. Ainsi, par exemple, un conducteur de ligne réunissant les pixels d'une ligne d'une matrice MP est en continuité avec un conducteur de ligne des matrices MP des autres circuits partiels.

A titre indicatif, on utilise des procédés de photorépétition de circuits partiels identiques sur une même puce pour des puces de grandes dimensions, c'est-à-dire au-dessus de 2 centimètres de large. Les temps de propagation sur des distances de cet ordre ne peuvent pas descendre au-dessous de 20 nanosecondes, ce qui n'est pas négligeable lorsqu'on veut travailler à des fréquences de plusieurs dizaines ou centaines de MHz. S'il y a N circuits partiels adjacents ayant chacun 2 centimètres de large, les temps de propagation jusqu'au dernier circuit partiel sont multipliés par N.

La figure 2 représente une architecture générale tirée de celle de la figure 1 mais dans laquelle on a représenté dans chaque circuit partiel identique une portion de surface réservée à un circuit CCMP de compensation des risques de mauvaise synchronisation due aux temps de propagation des signaux d'un circuit partiel à un autre. Ce circuit CCMP, identique dans les différents circuits partiels, comprend essentiellement les éléments suivants : une entrée d'horloge amont, une sortie d'horloge aval, une ligne de transmission principale entre cette entrée et cette sortie, une ligne de compensation à sorties multiples, et un multiplexeur relié aux sorties multiples. Le multiplexeur fournit un signal d'horloge locale au reste du circuit partiel. Ce qui est dit ici des signaux d'horloge issus au départ d'une horloge maître CLK provenant du séquenceur SEQ peut s'appliquer à d'autres signaux de commande que le signal d'horloge maître et pour simplifier les explications on ne considérera que la compensation du signal d'horloge maître CLK.

La portion de circuit de compensation CCMP est plus précisément représentée à la figure 3, pour un circuit partiel de rang intermédiaire i où i est un indice de 1 à N s'il y a N circuits partiels adjacents identiques. Dans cet exemple, N=3.

L'entrée de signal d'horloge amont est désignée par EH_{AMi}. La sortie de signal d'horloge aval est désignée par SH_{AVi}, et est reliée directement à l'entrée de signal d'horloge amont du circuit partiel immédiatement suivant. La liaison est une liaison par simple aboutement des motifs des deux circuits partiels, la ligne principale étant une ligne continue s'étendant à travers la succession de circuits partiels. L'entrée EH_{AMi} reçoit un signal d'horloge amont CLKᵢ d'un circuit partiel de rang précédent et la sortie SH_{AVi} transmet un signal d'horloge aval CLKᵢ₊₁ à un circuit partiel de rang suivant s'il y en a. Le premier circuit partiel, de rang 1 reçoit un signal d'horloge amont CLK₁ qui est le signal d'horloge maître CLK issu du séquenceur des figures 1 et 2.

La ligne conductrice principale transmettant le signal d'horloge d'un circuit partiel au suivant est désignée par LP ; elle s'étend entre l'entrée EH_{AMi} et la sortie SH_{AVi}, et a une longueur L qui provoque un retard de transmission de durée T des fronts de transition des signaux d'horloge qui sont propagés sur cette ligne. Dans la configuration la plus simple, la ligne principale LP est une ligne conductrice droite allant directement de l'entrée vers la sortie et ayant une longueur égale à la largeur du circuit partiel (largeur comptée dans la direction de juxtaposition des circuits partiels, c'est-à-dire dans le sens horizontal sur toutes les figures. Elle introduit inévitablement un retard de propagation de durée T entre les fronts de montée du signal d'horloge amont CLKᵢ présent sur l'entrée EH_{AMi} et les fronts de montée du signal d'horloge aval CLKᵢ₊₁ présent sur la sortie SH_{AVi}. Ce retard provient d'une part de la vitesse de propagation non infinie des électrons et d'autre part des constantes de temps résultant des propriétés résistives, capacitices et inductives de la ligne. On verra que la ligne principale peut comporter en outre d'autres éléments introduisant un retard, notamment un amplificateur tampon BF, inséré entre l'entrée et la sortie de la ligne pour régénérer le signal d'horloge. Dans ce cas, le retard nécessairement introduit par cet amplificateur fait partie du retard global de durée T introduit par la ligne.

Une ligne conductrice de compensation LS à sorties multiples est organisée en plusieurs tronçons de ligne en série, avec une sortie respective S1, S2, S3 aux extrémités des tronçons.

La ligne de compensation est reliée à la ligne principale en un point quelconque de celle-ci et s'étend de la ligne principale vers une première sortie de ligne S1. La distance entre le point de liaison avec la ligne principale et la première sortie importe peu, mais elle est évidemment la même pour tous les circuits partiels. Chaque tronçon a ensuite une longueur égale à la longueur L de la ligne principale ou, plus précisément, est configuré pour introduire un retard de propagation de durée T comme la ligne principale. S'il y a un amplificateur tampon dans la ligne principale, contribuant au retard T, on introduira un amplificateur tampon semblable dans chaque tronçon de la ligne de compensation afin d'obtenir ce retard de propagation T dans chaque tronçon.

Sur la figure 3, en raison du fait qu'on souhaite avoir trois circuits partiels juxtaposés comme à la figure 2, il y a trois sorties S1, S2, S3 de la ligne de compensation et deux tronçons avec un retard T chacun, respectivement entre les sorties S1 et S2, et S2 et S3. Plus généralement s'il y a N circuits partiels, il y a N sorties successives de rang i = 1 à N et ces sorties fournissent un signal d'horloge avec des retards successifs (par rapport au signal d'horloge amont) qui décalés les uns des autres de la durée T. Ainsi, quel que soit le retard de propagation existant entre l'entrée EH_{AMi} et la sortie S1, le retard sera augmenté de T sur la sortie S2 et de 2T sur la sortie S3 ; plus généralement, s'il y a N sorties, il est augmenté de (i-1)T sur la sortie de rang i.

Les sorties de la ligne de compensation sont reliées chacune à une entrée respective d'un multiplexeur MUX. Les longueurs de connexion entre les sorties de la ligne de compensation et les entrées du multiplexeur sont identiques ou pratiquement identiques pour ne pas introduire de retards de propagation significativement différents (par rapport au retard T de la ligne principale) entre ces sorties et le multiplexeur. Une entrée de rang quelconque j du multiplexeur est reliée à une sortie de rang S_{N-j+1} de la ligne de compensation.

Le multiplexeur est commandé par des lignes de commande LC qui définissent quelle est l'entrée de multiplexeur, donc quelle est la sortie de ligne de compensation, qui sera transmise sur la sortie du multiplexeur. Pour le circuit partiel de rang i, la ligne de commande LC fournit un signal selᵢ de sélection de l'entrée de rang i du multiplexeur, donc une sélection de la sortie de rang N-i+1 de la ligne de compensation. Les états des lignes de commande sont statiques au moment de l'utilisation du circuit de compensation.

C'est le signal présent sur cette sortie de rang N-i+1 qui sera transmis en sortie du multiplexeur. La sortie du multiplexeur du circuit de rang i fournit alors un signal d'horloge locale ClkLᵢ qui sera utilisé dans le circuit partiel de rang i ; ce signal est par exemple transmis, pour être utilisé, au circuit de contrôle CTRL correspondant. Les signaux d'horloge locale des différents circuits partiels sont simultanés en raison de la compensation établie par la ligne de compensation.

Le retard existant entre le signal d'horloge locale ClkLᵢ et le signal d'horloge maître CLK n'est pas précisément connu : il dépend de l'emplacement du point de jonction entre la ligne principale et la ligne de compensation (distance entre ce point de jonction et l'entrée EH_{AMi}) ; il dépend de la distance entre ce point de jonction et la première sortie S1 de la ligne de compensation ; il dépend de la longueur de connexion entre les sorties de la ligne de compensation et le multiplexeur ; il dépend du retard propre introduit par le multiplexeur ; il dépend de la longueur de connexion en sortie du multiplexeur. Mais ces éléments de retard sont les mêmes pour tous les circuits partiels ; quel que soit le retard qu'ils introduisent, on peut dire qu'il n'y a pas de retard entre un signal d'horloge locale ClkLᵢ et un signal d'horloge locale ClkLᵢ₊₁ d'un circuit partiel adjacent ; en effet, le retard T introduit par la longueur de la ligne principale pour aller d'un circuit partiel au circuit partiel suivant est intégralement compensé par le fait que le circuit partiel de rang i utilise la sortie de rang N-i+1 de la ligne secondaire alors que le circuit partiel suivant de rang i+1 utilise la sortie de rang précédent N-i de la ligne de compensation, ces deux sorties étant séparées par un tronçon introduisant le même retard de propagation T que la ligne principale.

Pour que chaque circuit partiel de rang i sélectionne l'entrée adéquate du multiplexeur, c'est-à-dire l'entrée de rang i reliée à la sortie de rang N-i+1 de la ligne de compensation, on prévoit de préférence que le multiplexeur possède des lignes de commande qui se propagent d'une entrée de commande du circuit partiel à une sortie de commande qui elle-même est reliée à l'entrée de commande du circuit partiel suivant (liaison par simple aboutement des motifs des circuits partiels juxtaposés) ; mais cette propagation se fait à chaque fois en incrémentant le rang de l'entrée sélectionnée ; en d'autres mots, le signal de commande propagé est légèrement différent du signal de commande reçu, mais la différence (incrémentation d'une unité) est la même pour tous les circuits partiels. Ainsi, bien que les circuits partiels et notamment l'organisation des lignes de commande soit exactement la même d'un circuit au suivant (incluant le circuit permettant l'incrémentation) on commande le multiplexeur du circuit partiel de rang i différemment du circuit partiel suivant. Le premier circuit partiel reçoit une commande qui sélectionne l'entrée de rang 1 donc la sortie de rang 1 (S3 sur la figure 2) de la ligne de compensation.

On voit sur la figure 3 les lignes de commande associées au multiplexeur du circuit partiel de rang i : elles reçoivent un signal de sélection selᵢ spécifique et transmettent vers le circuit de rang suivant i+1 un signal selᵢ₊₁. Un circuit d'incrémentation d'une unité, désigné par INCR, est alors inséré entre les lignes de commande arrivant au multiplexeur et les sorties de commande destinées au circuit partiel suivant.

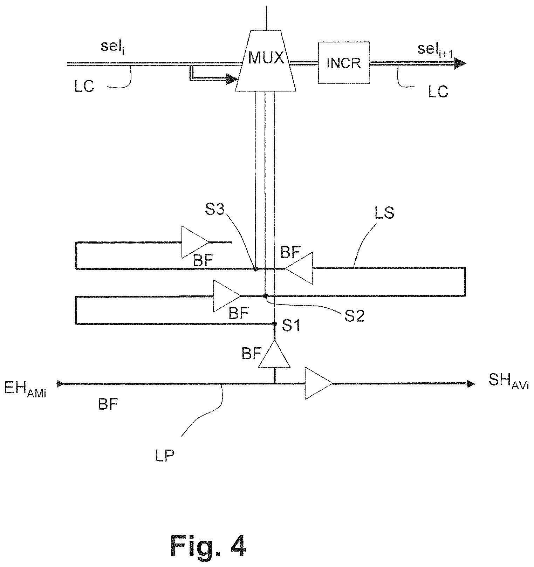

Sur la figure 4, on a représenté en vue agrandie la ligne principale LP et la ligne de compensation LS dans le cas où la ligne principale comporte au moins un amplificateur tampon dont la fonction est de restaurer l'amplitude du signal d'horloge transmis, celui-ci ayant tendance à s'affaiblir au cours de sa propagation sur la ligne principale. Dans ce cas, l'amplificateur tampon (désigné par l'appellation générique BF sur la figure 4) introduit un retard supplémentaire de propagation des fronts d'horloge. La durée T de retard de propagation de la ligne principale comprend la somme de ce retard et du retard propre de la ligne conductrice elle-même. Il faut alors prévoir dans chaque tronçon de la ligne de compensation LS un retard identique T, et le mieux est donc d'insérer dans chaque tronçon un amplificateur tampon BF identique à l'amplificateur inséré dans la ligne principale.

Dans l'exemple de la figure 4, l'amplificateur tampon est placé immédiatement à l'entrée de la ligne principale, et on a prévu un amplificateur BF inséré dans le premier tronçon de ligne de compensation entre la sortie S1 et la sortie S2, puis un autre amplificateur BF inséré dans le deuxième tronçon entre la sortie S2 et la sortie S3.

En outre, étant donné que le retard propre introduit par un amplificateur peut dépendre de la charge de cet amplificateur, on s'arrange autant que possible pour que les charges de tous ces amplificateurs soient identiques. C'est pourquoi on peut prévoir, comme visible sur la figure 4, que la ligne de compensation LS se prolonge, en aval de la sortie S3, par un tronçon de ligne chargé par un amplificateur. De même, on peut prévoir que la ligne de compensation comporte, en amont de la sortie S1, un amplificateur entre la ligne principale et la sortie S1. Enfin, la charge de l'amplificateur BF de la ligne principale est constituée par la ligne principale elle-même chargée par l'amplificateur BF de la ligne principale du circuit partiel situé immédiatement en aval.

De cette manière, tous les amplificateurs situés entre la ligne principale et la dernière sortie S3 sont chargés sensiblement par la même impédance qui est principalement l'impédance d'un tronçon de ligne chargé par un amplificateur.

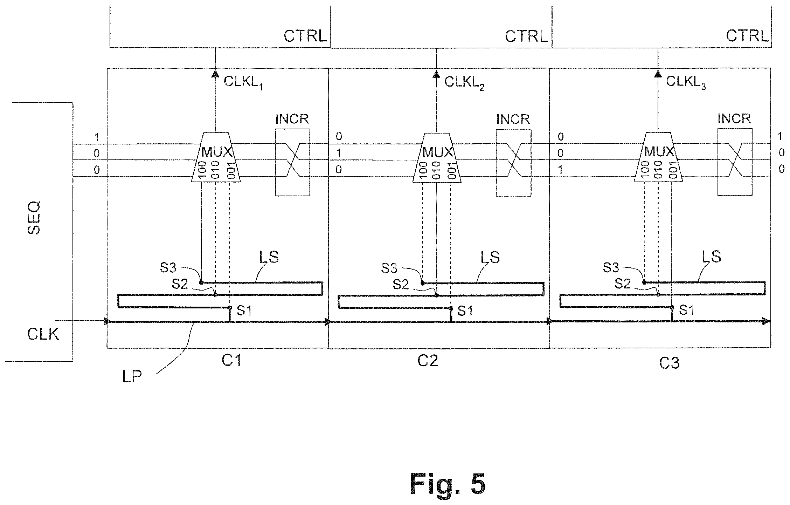

La figure 5 représente un exemple de réalisation des lignes de commande du multiplexeur, permettant d'assurer l'incrémentation du rang de l'entrée du multiplexeur, donc la décrémentation du rang de la sortie sélectionnée par le multiplexeur. Dans cet exemple, il y a autant de lignes de commande qu'il y a de circuits partiels et le multiplexeur reçoit les N lignes de commande ; une seule de ces lignes reçoit un niveau logique actif (1) et le multiplexeur est agencé pour sélectionner l'entrée de rang i lorsque la ligne de commande de rang i est activée ; les autres lignes reçoivent un niveau non actif (0). L'entrée de rang i est reliée à la sortie de rang N-i+1 de la ligne de compensation et c'est alors le signal d'horloge présent sur cette sortie qui sera transmis sur la sortie du multiplexeur. Sur la figure 5, on a représenté en traits pleins la liaison entre une entrée de multiplexeur et la sortie sélectionnée, et en traits pointillés les liaisons avec les sorties non sélectionnées, et ceci pour chacun des trois circuits partiels représentés. La configuration est transposable à N circuits partiels, en utilisant alors N lignes de commande pour les multiplexeurs.

Le circuit d'incrémentation peut-être, comme représenté à la figure 5, simplement un circuit de permutation circulaire des lignes de commande : une ligne de rang j quelconque dans un circuit partiel de rang i devient une ligne de rang j+1 dans le circuit partiel de rang i+1. En particulier, la ligne de rang i dans le circuit partiel de rang i sélectionne la sortie de rang N-i+1 de ce circuit partiel, puis se prolonge en une ligne de rang i+1 dans le circuit suivant de rang i+1 et elle sélectionne la sortie de rang N-i de ce circuit suivant.

D'autres circuits d'incrémentation pourraient être prévus, en utilisant notamment des registres à décalage dont l'incrémentation est assurée par le circuit partiel pour qu'après une phase d'initialisation du circuit intégré les registres à décalage contiennent des codes (001, 010, 100) différents pour chaque circuit partiel, ces codes commandant la sélection d'entrées différentes du multiplexeur. Le multiplexeur peut également décoder des codes de comptage plus classiques tels que des codes binaires (00, 01, 10) ou Gray (00, 01, 11), notamment si on utilise des registres à décalage.

L'invention s'applique principalement aux circuits intégrés formés par photorépétition, mais peut plus généralement s'appliquer à tout circuit intégré formé par une pluralité de motifs adjacents identiques, indépendamment de leur mode de fabrication.

## Revendications

1. Circuit intégré comprenant N motifs adjacents tous identiques, correspondant à N circuits partiels identiques adjacents (C1, C2, C3) de rang i = 1 à i = N dans l'ordre de succession géographique des circuits partiels, chaque circuit partiel comprenant une entrée de signal d'horloge amont (EH_{Ami}), une sortie de signal d'horloge aval (SH_{Av}) et une ligne conductrice principale (LP) s'étendant entre l'entrée de signal d'horloge amont (EH_{Ami}) et la sortie de signal d'horloge aval (SH_{Av}) et introduisant un retard de propagation de durée T, la sortie de signal d'horloge aval (SH_{Av}) de chaque circuit partiel, sauf celui de rang N, étant reliée directement à l'entrée de signal d'horloge amont (EH_{Ami}) du circuit partiel immédiatement suivant de telle sorte que les lignes conductrices principales (LP) des circuits partiels permettent la transmission en cascade d'un signal maître (CLK) reçu sur le circuit partiel de rang 1, , **caractérisé en ce qu'**il comprend dans chaque circuit partiel de rang i :
- une ligne conductrice de compensation (LS) à N sorties successives (S1, S2, S3) de rang i = 1 à N, reliée à la ligne principale (LP) du circuit partiel et établissant un retard de propagation de durée T entre les sorties successives,
- un multiplexeur (MUX) à N entrées reliées respectivement à chacune des N sorties de la ligne conductrice de compensation, et
- des lignes de commande (LC) du multiplexeur, agencées pour sélectionner l'entrée de rang i du multiplexeur, reliée à la sortie de rang N-i+1 parmi les N sorties de la ligne conductrice de compensation,
la sortie du multiplexeur du circuit partiel de rang i fournissant ainsi un signal local (ClkLᵢ) pour ce circuit partiel ;
et **en ce que** :
- les lignes de commande du multiplexeur du circuit partiel de rang 1 sont configurées pour recevoir un signal de sélection de l'entrée de rang N de ce multiplexeur et pour propager ce signal d'un multiplexeur au suivant en le modifiant à chaque fois pour incrémenter d'une unité le rang de l'entrée sélectionnée, afin que les lignes de commande aboutissant au multiplexeur du circuit partiel de rang i sélectionnent la sortie de rang N-i+1 de la ligne de compensation et transmettent au multiplexeur du circuit partiel de rang i+1 une commande de sélection de la sortie de rang N-i.

2. Circuit intégré selon la revendication 1, **caractérisé en ce que** le signal maître est un signal d'horloge général et le signal local issu du multiplexeur de rang i est un signal d'horloge locale pour le circuit partiel de rang i.

3. Circuit intégré selon l'une des revendications 1 et 2, **caractérisé en ce que** les lignes de commande du multiplexeur du circuit partiel de rang i sont :
- au nombre de N,
- configurées de telle sorte que l'activation d'une ligne de commande de rang i, les autres lignes de commande étant inactives, permette de sélectionner la sortie de rang N-i+1 de la ligne de compensation, et
- reliées directement aux lignes de commande du multiplexeur du circuit partiel de rang i+1 avec une permutation circulaire pour que la ligne de commande active de rang i du multiplexeur du circuit partiel de rang i soit reliée à une ligne de commande de rang i+1 du multiplexeur du circuit partiel de rang i+1, cette dernière ligne étant configurée pour sélectionner, lorsqu'elle est active, la sortie de rang N-i de la ligne de compensation du circuit partiel de rang i+1.

4. Circuit intégré selon l'une des revendications 1 à 3, **caractérisée en ce qu'**un amplificateur tampon (BF) respectif est inséré dans la ligne principale et un amplificateur tampon identique respectif (BF) est inséré dans la ligne de compensation (LS) entre chaque sortie de celle-ci et la sortie de rang immédiatement suivant de la ligne.

## Patentansprüche

1. Integrierter Schaltkreis, beinhaltend N benachbarte, sämtlich identische Motive, welche N identischen benachbarten Teilschaltkreisen (C1, C2, C3) des Ranges i = 1 bis i = N in der geografischen Abfolge der Teilschaltkreise entsprechen, wobei jeder Teilschaltkreis einen vorgelagerten Uhrsignal-Eingang (EH_{Ami}), einen nachgelagerten Uhrsignal-Ausgang (SH_{Av}) und eine Hauptleitung (LP) beinhaltet, welche sich zwischen dem vorgelagerten Uhrsignal-Eingang (EH_{Ami}) und dem nachgelagerten Uhrsignal-Ausgang (SH_{Av}) erstreckt und eine Laufzeitverzögerung mit einer Dauer T einbringt, wobei der nachgelagerte Uhrsignal-Ausgang (SH_{Av}) eines jeden Teilschaltkreises, ausgenommen desjenigen mit Rang N, direkt mit dem vorgelagerten Uhrsignal-Eingang (EH_{Ami}) des unmittelbar nachfolgenden Teilschaltkreises in einer Weise verbunden ist, dass die Hauptleitungen (LP) der Teilschaltkreise die Kaskadenübertragung eines Mastersignals (CLK) ermöglichen, welches an dem Teilschaltkreis des Ranges 1 empfangen wurde, **dadurch gekennzeichnet, dass** er in jedem Teilschaltkreis des Ranges i Folgendes beinhaltet:
- eine Kompensationsleitung (LS) mit N aufeinanderfolgenden Ausgängen (S1, S2, S3) des Ranges i = 1 bis N, verbunden mit der Hauptleitung (LP) das Teilschaltkreises, und welche eine Laufzeitverzögerung mit einer Dauer T zwischen den aufeinanderfolgenden Ausgängen herstellt,
- einen Multiplexer (MUX) mit N jeweils mit jedem der N Ausgänge der Kompensationsleitung verbundenen Eingängen, und
- Steuerleitungen (LC) des Multiplexers, welche angeordnet sind, um denjenigen Eingang des Ranges i des Multiplexers auszuwählen, welcher mit dem Ausgang des Ranges N-i+1 unter den N Ausgängen der Kompensationsleitung verbunden ist,
wobei der Ausgang des Multiplexers des Teilschaltkreises des Ranges i somit ein lokales Signal (ClkLᵢ) für diesen Teilschaltkreis bereitstellt;
und dadurch, dass:
- die Steuerleitungen des Multiplexers des Teilschaltkreises des Ranges 1 konfiguriert sind, um ein Signal zur Auswahl des Eingangs des Ranges N dieses Multiplexers zu empfangen und um dieses Signal von einem Multiplexer an den nächsten zu propagieren, wobei sie dieses jedes Mal ändern, um den Rang des gewählten Eingangs um eine Einheit zu inkrementieren, damit die Steuerleitungen, welche am Multiplexer des Teilschaltkreises des Ranges i enden, den Ausgang des Ranges N-i+1 der Kompensationsleitung auswählen und an den Multiplexer des Teilschaltkreises des Ranges i+1 einen Auswahlbefehl des Ausgangs des Ranges N-i übertragen.

2. Integrierter Schaltkreis nach Anspruch 1, **dadurch gekennzeichnet, dass** das Mastersignal ein allgemeines Uhrsignal ist, und dass das vom Multiplexer des Ranges i stammende lokale Signal ein lokales Uhrsignal für den Teilschaltkreis des Ranges i ist.

3. Integrierter Schaltkreis nach einem der Ansprüche 1 und 2, **dadurch gekennzeichnet, dass** die Steuerleitungen des Multiplexers des Teilschaltkreises des Ranges i Folgendes sind:
- N an der Zahl,
- so konfiguriert, dass die Aktivierung einer Steuerleitung das Ranges i, wobei die restlichen Steuerleitungen inaktiv sind, die Auswahl des Ranges N-i+1 der Kompensationsleitung ermöglicht, und
- direkt mit den Steuerleitungen des Multiplexers des Schaltkreises des Ranges i+1 mit einer Kreispermutation verbunden, damit die aktive Steuerleitung des Ranges i des Multiplexers des Schaltkreises des Ranges i mit einer Steuerleitung des Ranges i+1 des Multiplexers des Schaltkreises des Ranges i+1 verbunden ist, wobei letztere Leitung konfiguriert ist, um, wenn sie aktiv ist, den Ausgang des Ranges N-i der Kompensationsleitung des Teilschaltkreises des Ranges i+1 auszuwählen.

4. Integrierter Schaltkreis nach einem der Ansprüche 1 bis 3, **dadurch gekennzeichnet, dass** ein jeweiliger Pufferverstärker (BF) in die Hauptleitung eingefügt ist, und ein jeweiliger identischer Pufferverstärker (BF) in die Kompensationsleitung (LS) zwischen jedem Ausgang dieser Leitung und dem Ausgang des unmittelbar darauffolgenden Ranges der Leitung eingefügt ist.

## Claims

1. An integrated circuit comprising N adjacent patterns, all identical, corresponding to N adjacent identical partial circuits (C1, C2, C3) of rank i=1 to i=N in the order of geographical succession of the partial circuits, each partial circuit comprising an upstream clock signal input (EH_{Ami}), a downstream clock signal output (SH_{AV}) and a main conducting line (LP) extending between the upstream clock signal input (EH_{Ami}) and the downstream clock signal output (SH_{AV}) and introducing a propagation delay of time T, the downstream clock signal output (SH_{AV}) of each partial circuit, except that of rank N, being directly linked to the upstream clock signal input (EH_{Ami}) of the partial circuit immediately following so that the main conducting lines (LP) of the partial circuits allow the cascade transmission of a master signal (CLK) received on the partial rank circuit of rank 1, **characterized in that** it comprises in each partial circuit of rank i:
- a compensation conducting line (LS) with N successive outputs (S1, S2, S3) of rank i = 1 to N, linked to the main line (LP) of the partial circuit and establishing a propagation delay of duration T between the successive outputs,
- a multiplexer (MUX) with N inputs linked respectively to each of the N outputs of the compensation conducting line, and
- control lines (LC) of the multiplexer, which are designed to select the multiplexer's input of rank i, linked to the output of rank N-i+1 from among the N outputs of the compensation conducting line,
the output of the multiplexer of the partial circuit of rank i thus providing a local signal (ClkLᵢ) for this partial circuit.
and **in that**:
- the control lines of the multiplexer of the partial circuit of rank 1 are configured to receive a signal for selecting the input of rank N of this multiplexer and to propagate this signal from one multiplexer to the following while modifying it each time so as to increment the rank of the selected input by one unit, so that the control lines ending at the multiplexer of the partial circuit of rank i select the output of rank N-i+1 of the compensation line and transmit to the multiplexer of the partial circuit of rank i+1 a command for selecting the output of rank N-i.

2. The integrated circuit according to claim 1, wherein the master signal is a general clock signal and the local signal arising from the multiplexer of rank i is a local clock signal for the partial circuit of rank i.

3. The integrated circuit according to claims 1 and 2, **characterized in that** the control lines of the multiplexer of the partial circuit of rank i are:
- N in number,
- configured in such a way that the activation of a control line of rank i, the other control lines being inactive, makes it possible to select the output of rank N-i+1 of the compensation line, and
- linked directly to the control lines of the multiplexer of the partial circuit of rank i+1 with a circular permutation so that the active control line of rank i of the multiplexer of the partial circuit of rank i is linked to a control line of rank i+1 of the multiplexer of the partial circuit of rank i+1, the latter line being configured to select, when it is active, the output of rank N-i of the compensation line of the partial circuit of rank i+1.

4. The integrated circuit according to any one of the preceding claims 1 to 3, **characterized in that** a respective buffer amplifier (BF) is inserted into the main line and a respective identical buffer amplifier (BF) is inserted into the compensation line (LS) between each output of the latter and the output of immediately following rank of the line.
